Europäisches Patentamt

European Patent Office

Office européen des brevets

(11) Veröffentlichungsnummer: **0 265 676**
A1

## (12) EUROPÄISCHE PATENTANMELDUNG

(21) Anmeldenummer: 87114107.3

(22) Anmeldetag: 26.09.87

(51) Int. Cl.⁴: **E06B 7/232** , E06B 5/18 , H05K 9/00

(30) Priorität: 25.10.86 DE 3636380

(43) Veröffentlichungstag der Anmeldung:
04.05.88 Patentblatt 88/18

(84) Benannte Vertragsstaaten:
DE FR GB IT NL SE

(71) Anmelder: **DORNIER GMBH**
**Postfach 1420**
**D-7990 Friedrichshafen 1(DE)**

(72) Erfinder: **Frischknecht, Erich**
**Schlehenweg 12**
**D-7990 Friedrichshafen 1(DE)**

(74) Vertreter: **Landsmann, Ralf, Dipl.-Ing.**
**c/o DORNIER GMBH Postfach 1420**
**D-7990 Friedrichshafen 1(DE)**

(54) **HF-Dichtung für Türen.**

(57) HF-Dichtung für Türen (2) von Kabinen oder Sheltersystemen, die aus Profilen (6, 16) und Sandwichplatten (8) bestehen, mit zwei umlaufenden - schräggestellten Kontaktflächen (10, 12), die sich bei geschlossener Tür (2) gegenüberliegen und einen Spalt bilden, und einer Federleiste (14) im Spalt, die mit der einen Kontaktfläche (10) fest verbunden ist und die andere Kontaktfläche (12) bei geschlossener Tür (2) berührt.

Fig. 1

EP 0 265 676 A1

## HF-Dichtung für Türen

Die Erfindung betrifft eine HF-Dichtung für Türen nach dem Oberbegriff des Anspruchs 1.

Bekannt sind HF-Dichtungen, die aus einem Drahtgeflecht mit kreisrundem Querschnitt bestehen, wobei im Inneren des Geflechts elastische Elemente eingelagert sein können. Diese Dichtungen konnten bisher die gestellten Forderungen nach HF-Dichtigkeit im Bereich von Eingängen wie Türen, Luken oder Signaleingängen von Kabinen oder Sheltersystemen nur bedingt erfüllen. Insbesondere hinsichtlich der Dämpfungsanforderungen und der mechanischen Beanspruchung und Festigkeit ergaben sich bisher bereits bei kürzeren Einsatzzeiten Probleme.

Aufgabe der Erfindung ist es, eine HF-Dichtung vorzuschla gen, die neben einer hohen HF-Dichtigkeit eine lange Lebensdauer aufweist, die aus einfachen, kostengünstigen Bauteilen besteht und - schnell montiert ist.

Diese Aufgabe wird erfindungsgemäß gelöst von einer HF-Dichtung mit den Merkmalen des Anspruchs 1. Ausgestaltungen der Erfindung sind Gegenstände von Unteransprüchen.

Die erfindungsgemäße Dichtung bietet eine gleichbleibende HF-Dichtigkeit auch bei großen Toleranzen der Bauteile.

In einer bevorzugten Ausführung ist die Kontaktfläche der Federleiste an der Tür angeordnet und ihre Normale weist in Richtung Innenseite der Kabine und Türmittelpunkt. Dadurch ist die Federleiste relativ gut geschützt angeordnet und wird auch bei geöffneter Tür nicht berührt. Die gegenüberliegende Kontaktleiste befindet sich dann im Rahmen versenkt und ist ebenfalls vor ungewünschten Berührungen weitgehend geschützt. Durch die besondere labyrinthische Formgebung der Tür und Rahmenprofile wird eine zusätzliche HF-Dämpfung erreicht, die an sich aus Labyrinth-Dichtungssystemen bereits bekannt ist. Die geneigte Anordnung der Dichtflächen verhindert zudem das Eindringen von Wasser ins Dichtsystem, wodurch Korrosionsprobleme an den HF-Kontakt stellen vermieden werden. Als günstig hat sich herausgestellt, daß die Kontaktflächen zur Türfläche einen Winkel von 30 bis 60°, bevorzugt um 45°, einschliessen. Dabei müssen die Kontaktflächen nicht parallel zueinander laufen, sondern können gegenseitig einen kleinen Winkel einschliessen, der zwischen 0 und 20° variiert und bevorzugt ca. 5° beträgt.

Eine weitere Erhöhung der Dämpfung wird dadurch erreicht, daß die Außenschale und die Innenschale der Kabine und auch der Tür galvanisch getrennt sind. Diese Trennung wird durch nichtleitende Einsatzstücke in den Rahmenprofilen erreicht. Die gedämpften Rahmenprofile bieten neben der erhöhten HF-Dichtung auch noch eine bessere Wärmedämmung.

Zur Erhöhung der Dichtheit gegen Wasser kann eine Gummidichtung im Türspalt vorgesehen sein. Die Dichtung wird bevorzugt von einem Hohlprofil gebildet, das an der Tür durch Einschnappen in vorgesehene Rastnuten befestigt ist und an einer schräggestellten Fläche am Rahmen anliegt.

In einer bevorzugten Ausführung ist ein Endanschlag vorgesehen, der eine übermäßige Deformierung der Federelemente verhindert, wenn die Tür zu fest geschlossen wird. Der Endanschlag wird z.B. durch einen vorstehenden Teil des Rahmens gebildet, der neben der Kontaktfläche angeordnet ist und an einem gegenüberliegenden Teil der Tür einen Anschlag hat.

Die Wasserdichtigkeit und der Korrosionsschutz des HF-Dichtsystems können durch eine umlaufende Regenrinne in der Tür verbessert werden. Die Rinne hat bevorzugt eine V-Form und ist hinter einer Gummidichtung angeordnet.

Die Federleiste besteht bevorzugt aus einer Vielzahl von Biegefedern, die bogenförmig verlaufen, an einem Ende fest mit ihrem Bauteil verbunden sind und am anderen Ende frei über ihre Kontaktfläche gleiten können. In ihrem Mittelteil gleiten die Federn beim Schliessen der Tür über die Kontaktfläche des Gegenstücks (Tür oder Rahmenprofil). Solche Federelemente sind als Stripfingers bereits für die Befestigung von Moduleelementen bekannt (Prospekt: RFI/EMI Shielding Strips der Tech-Etch Inc., Massachusetts, USA). Die Federelemente können dadurch geschützt werden, daß ein Vorsprung im Türprofil vorgesehen ist, der zusammen mit der Kontaktfläche eine Nut bildet, in der sich die freien Enden der Biegefedern bewegen können. Durch diesen Vorsprung sind die Federelemente vor einer Deformation durch unbeabsichtigtes Berühren oder Herausziehen geschützt.

Zur einfacheren Montage kann vorgesehen sein, daß die Feder leiste mit ihrem festen Ende um ihr Bauelement (Türprofil) herumgreift und mit einem Vorsprung in dem Profil festgeschnappt ist. Eine solche Schnappbefestigung bietet einen sehr guten Stromübergang und macht Lötungen, Schraub-oder Schweißverbindungen überflüssig.

Die Federleiste besteht bevorzugt aus einer Kupfer-Beryllium-Legierung (25 (CA 172)), die hohe Elastizität mit guter elektrischer Leitung und einem guten Stromübergang zum Aluminium, dem üblichen Werkstoff für Profilleisten, verbindet. Die Maße der Biegefedern sind abhängig von der Profilierung von Tür und Rahmen. Bevorzugt werden 0,1 bis 0,2 mm starke Federn, wobei die Finger 8 bis 9 mm breit sind und der Spalt zwischen den Fingern 0,5 bis 1 mm breit ist. Die Federn haben bevorzugt blanke, glänzende Oberflächen. Möglich sind auch Chromat-, Zinn-, Zink oder Cadmium-Chromatoberflächen.

Durch die Schrägstellung der Kontaktflächen entsteht beim Anpressen der Tür eine schleifende Bewegung der Federelemente auf dem Rahmenprofil, so daß eine Selbstreinigung der Kontaktflächen erfolgt. Die Selbstreinigung kann dadurch erhöht werden, daß die Kontaktflächen dort mit Riffelungen versehen sind, wo die Federelemente der gegenüberliegenden Bauteile über sie gleiten.

Durch die umlaufende Bestückung der Tür mit Federelementen wird eine vibrationsfreie Aufhängung der Tür bei mobilen Systemen sichergestellt. Scharniere und Schlösser werden dabei entlastet. Die Verwendung unterschiedlichster Schließsysteme oder Scharnierausführungen ist problemlos möglich, wenn die Türprofile relativ große Befestigungsflächen aus Aluminium aufweisen.

Neben gebräuchlichen einfachen Türscharnieren können auch Scharniere verwendet werden, die Bewegungen um zwei parallele Achsen erlauben, so daß die Tür beim Schliessen in Richtung ihrer Normalen bewegt wird und an allen Kontaktflächen gleichmäßig angepresst wird.

Die Erfindung wird anhand zweier Figuren näher beschrieben.

Figur 1 zeigt den Schnitt durch eine erfindungsgemäße HF-Dichtung,

Figur 2 zeigt eine erfindungsgemäße Federleiste.

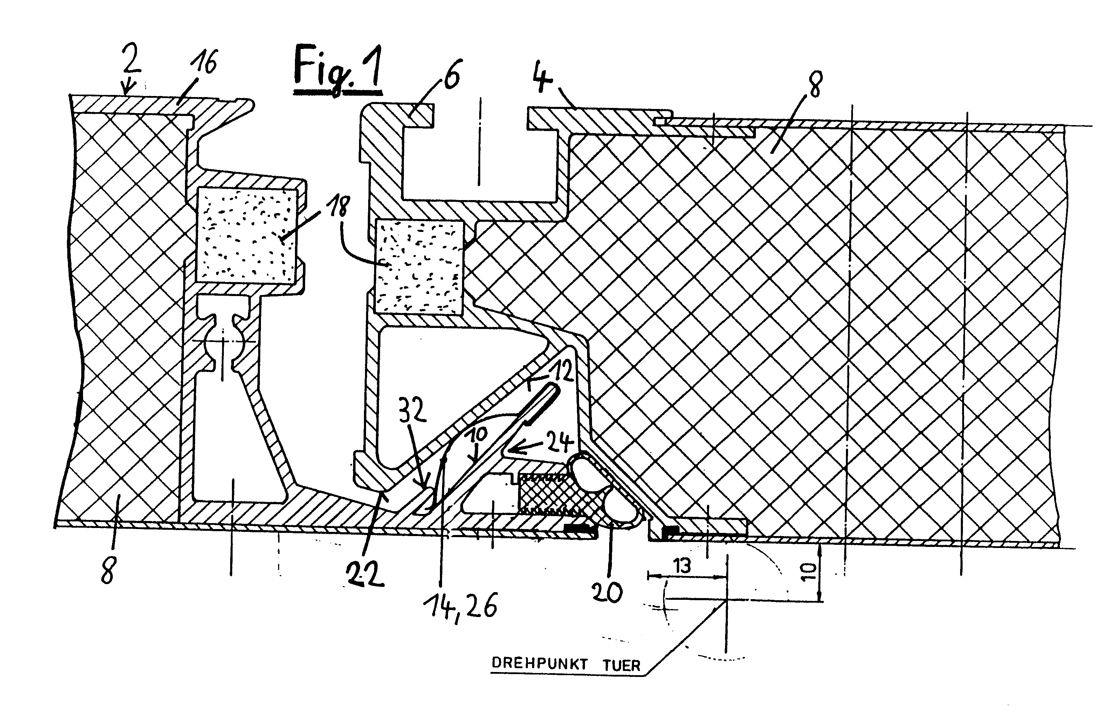

Figur 1 zeigt die Tür 2 und den Rahmen 4, bestehend aus Sandwichplatten 8 und Profilteilen 6 und 16. Die HF-Dichtung wird gebildet durch die verdeckt liegenden Kontaktflächen 10 und 12 sowie durch die Federleiste 14. Tür 2 und Rahmen 4 sind durch die Profilstücke 18, die bevorzugt aus hochverdichtetem Hartschaum bestehen, elektrisch und bezüglich der Wärmeleitung in zwei Teile getrennt. Die Gummidichtung 20 schützt die HF-Dichtung gegen eindringendes Spritzwasser. Die V-förmige Regenrinne 24 leitet dennoch eingedrungenes Wasser ab. Mit 22 ist ein Anschlag am Rahmen bezeichnet, der bei zu festem Schliessen der Tür 2 ein Zusammenquetschen der Federleiste 14 verhindert.

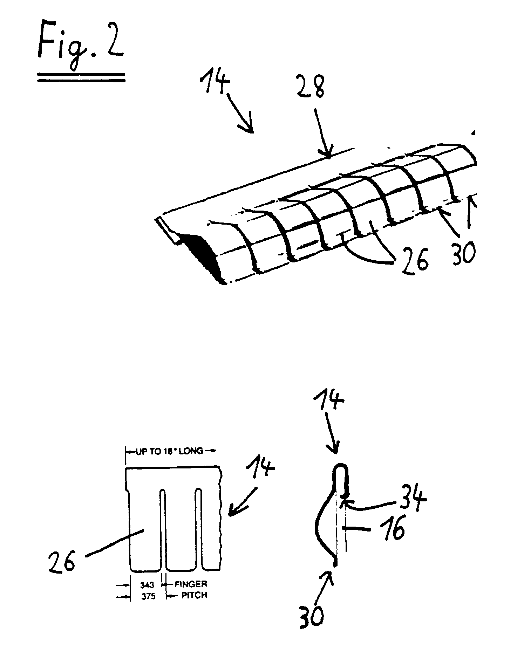

Figur 2 zeigt eine Federleiste 14, bestehend aus einzelnen Biegefedern 26. Die festen Enden 28 der Biegefedern 26 umgreifen das Profilstück 16. Die freien Enden 30 können über dem Profilstück gleiten.

## Ansprüche

1. HF-Dichtung für Türen (2) von Kabinen oder Sheltersystemen, die aus Profilen (6, 16) und Sandwichplatten (8) bestehen, **gekennzeichnet** durch
-zwei umlaufende schräggestellte Kontaktflächen (10, 12), die sich bei geschlossener Tür (2) gegenüberliegen und einen Spalt bilden und
-eine Federleiste (14) im Spalt, die mit der einen Kontaktfläche (10) fest verbunden ist und die andere Kontaktfläche (12) bei geschlossener Tür (2) berührt.

2. HF-Dichtung nach Anspruch 1, dadurch gekennzeichnzeichnet, daß die Kontaktfläche (10) mit der Federleiste (14) an der Tür (2) angeordnete ist und zur Innenseite der Kabine und zur Türmitte hin schräggestellt ist und daß die zweite Kontaktfläche (12) im Rahmen (4) versenkt ange ordnet ist.

3. HF-Dichtung nach einem der vorhergehenden Ansprüche, dadurch gekennzeichnet, daß die Kontaktflächen (10, 12) zusammen mit dem Rahmen (4) und der Tür (2) ein Labyrinth bilden, wobei ein Spalt in Form eines z oder mit mehr Umlenkungen gebildet ist.

4. HF-Dichtung nach einem der vorhergehenden Ansprüche, dadurch gekennnzeichnet, daß die Kontaktflächen (10, 12) bei geschlossener Tür (2) mit der Kabinenwand einen Winkel von 30 bis 60°, bevorzugt um 45°, einschliessen.

5. HF-Dichtung nach einem der vorhergehenden Ansprüche, dadurch gekennzeichnet, daß die Kontaktflächen (10, 12) bei geschlossener Tür (2) einen kleinen Winkel zwischen 0 und 20°, bevorzugt um 5°, gegeneinander einschliessen.

6. HF-Dichtung nach einem der vorhergehenden Ansprüche, dadurch gekennzeichnet, daß die Profile (6, 16) des Rahmens (4) und der Tür (2) aus je zwei voneinander durch einen Nichtleiter (18) getrennten Teilen gebildet sind, so daß die Innenschale der Kabine elektrisch von der Außenschale getrennt ist.

7. HF-Dichtung nach einem der vorhergehenden Ansprüche, gekennzeichnet durch eine Gummidichtung (20) im Türspalt, die bevorzugt an der Tür (2) befestigt ist und an einer nach aussen und zur Türmitte hin gerichteten Fläche am Rahmen (4) anliegt.

8. HF-Dichtung nach einem der vorhergehenden Ansprüche, gekennzeichnet durch einen Anschlag (22), der eine übermäßige Deformierung der Federleiste (14) verhindert.

9. HF-Dichtung nach einem der vorhergehenden Ansprüche, gekennzeichnet durch eine V-förmige Regenrinne (24) im Profil (16) der Tür (2).

10. HF-Dichtung nach einem der vorhergehenden Ansprüche, dadurch gekennzeichnet, daß die Federleiste (14) eine Vielzahl von Biegefedern (26) enthält, die bogenförmig verlaufen, an einem Ende (28) fest mit ihrer Kontaktfläche (10) verbunden sind und mit dem anderen Ende (30) über ihre Kontaktfläche (10) gleiten können.

11. HF-Dichtung nach Anspruch 10, gekennzeichnet durch einen Vorsprung (32), der mit der Kontaktfläche (10) der Federleiste (14) eine Nut bildet, in der sich die freien Enden (30) der Biegefedern (26) bewegen können.

12. HF-Dichtung nach einem der vorhergehenden Ansprüche, dadurch gekennzeichnet, daß die Federleiste (14) mit ihrem festen Ende (28) um ihre Kontaktfläche (10) herumgreift und mit mindestens einem Vorsprung (34) an dem Profil (6, 16) festgeschnappt ist.

13. HF-Dichtung nach einem der vorhergehenden Ansprüche, dadurch gekennzeichnet, daß der Federleiste (14) aus Cu-Be besteht,bevorzugt aus 1,8 bis 2,0% Be, mindestens 0,2% Co + Ni, maximal 0,6% Co + Ni + Fe, Rest Cu, die Biegefedern (26) 0,13 mm stark, 8,7 mm breit und die Spalte zwischen ihnen 0,8 mm breit sind.

14. HF-Dichtung nach einem der vorhergehenden Ansprüche, gekennzeichnet durch eine Riffelung der Kontaktfläche (12), die der Federleiste (14) gegenüberliegt.

15. HF-Dichtung nach einem der vorhergehenden Ansprüche, gekennzeichnet durch ein Scharnier, das Bewegungen um zwei parallele Achsen erlaubt, so daß die Tür (2) beim Schliessen in Richtung ihrer Normalen bewegt wird.

Fig. 1

# Fig. 2

UP TO 18" LONG

| | |
|---|---|
| 343 | FINGER |
| 375 | PITCH |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| X | US-A-3 437 735 (C.R. SCHALLER, JR.) <br> * ganzes Dokument * <br> --- | 1-5,10, 13 | E 06 B 7/232 <br> E 06 B 5/18 <br> H 05 K 9/00 |
| A | US-A-4 069 618 (C. GEISS) <br> * ganzes Dokument * <br> --- | 1,3,10, 12,13 | |
| A | DE-U-8 512 638 (LICENTIA PATENT-VERWALTUNGS-GMBH) <br> * Figuren 1-4; Seite 6, Absatz 6 * <br> --- | 7 | |
| A | EP-A-0 095 743 (OY EURAMECANO AB) <br> * Figuren 1, 2; Ansprüche 6, 7 * <br> ----- | 15 | |

**RECHERCHIERTE SACHGEBIETE (Int. Cl.3)**

E 06 B 5/00
G 12 B 17/00
H 05 K 9/00

Der vorliegende Recherchenbericht wurde für alle Patentansprüche erstellt

| Recherchenort | Abschlußdatum der Recherche | Prüfer |
|---|---|---|
| BERLIN | 04-01-1988 | KRABEL A.W.G. |

EPO FORM 1503 03.82 (P0403)